# EUROPÄISCHE PATENTSCHRIFT

(11) **EP 1 206 804 B1**
(45) Veröffentlichungstag und Bekanntmachung des Hinweises auf die Patenterteilung: **07.06.2006**
(21) Anmeldenummer: 00962179.8
(22) Anmeldetag: 02.08.2000
(51) Int. Cl.: H01L 41/047, H01L 41/083

(54) **ELEKTRODENKONTAKT FÜR EINEN PIEZOKERAMISCHEN AKTOR SOWIE HERSTELLUNGSVERFAHREN**
ELECTRODE CONTACT FOR A PIEZOCERAMIC ACTUATOR AND METHOD FOR PRODUCING SAME
CONTACT POUR ELECTRODES D'UN ACTIONNEUR PIEZOCERAMIQUE ET SON PROCEDE DE REALISATION

(30) Priorität: 06.08.1999 DE 19936713
(43) Veröffentlichungstag der Anmeldung: 22.05.2002
(73) Patentinhaber: ROBERT BOSCH GMBH, 70442 Stuttgart (DE)
(72) Erfinder: HENNEKEN, Lothar, D-71638 Ludwigsburg (DE); GLOCK, Armin, D-73660 Urbach (DE); HACKENBERG, Juergen, D-74343 Sachsenheim (DE)
(86) Internationale Anmeldenummer: PCT/DE2000/002527
(87) Internationale Veröffentlichungsnummer: WO 2001/011699

(56) Entgegenhaltungen:
- DE-A- 4 224 284
- DE-A- 19 753 930
- US-A- 5 459 371
- PATENT ABSTRACTS OF JAPAN vol. 010, no. 042 (E-382), 19. Februar 1986 (1986-02-19) & JP 60 196981 A (NEC CORP), 5. Oktober 1985 (1985-10-05) -& JP 60 196981 A (NEC CORP) 5. Oktober 1985 (1985-10-05)
- PATENT ABSTRACTS OF JAPAN vol. 011, no. 081 (E-488), 12. März 1987 (1987-03-12) & JP 61 234580 A (JGC CORP), 18. Oktober 1986 (1986-10-18)

## Beschreibung

### Stand der Technik

Die Erfindung bezieht sich auf einen piezokeramischen Aktor, im wesentlichen bestehend aus einem gesinterten monolithischen Stapel dünner piezokeramischer Folien mit zwischen den Folien angeordneten Innenelektroden, welche auf der Außenseite des Stapels unter Bildung zumindest zweier elektrisch voneinander getrennter Elektrodengruppen mit alternierend aufeinanderfolgenden Innenelektroden der zumindest zwei Gruppen miteinander elektrisch verbunden sind.

Derartige Aktoren sind allgemein bekannt.

Piezokeramische Materialien haben die Eigenschaft, sich bei Beaufschlagung mit mechanischen Kräften, d.h. insbesondere unter mechanischem Druck oder Zug, elektrisch aufzuladen. Andererseits bewirkt ein auf das piezokeramische Material angelegtes elektrisches Feld, daß sich das Material mechanisch verspannt, d.h. insbesondere ausdehnt oder zusammenzieht.

Diese letzteren Effekte werden bei Aktoren ausgenutzt, um Stellbewegungen auszuführen.

Durch den Aufbau des Aktors aus einem Stapel piezokeramischer Folien mit entsprechend vielen Innenelektroden kann auch bei begrenzter elektrischer Betriebsspannung eine hohe elektrische Feldstärke innerhalb der piezokeramischen Folien erreicht werden, da im Falle von zwei Elektrödengruppen jeweils zwischen zwei benachbarten Innenelektroden die Betriebsspannung anliegt.

In der Praxis kann die Kontaktierung der Innenelektroden Schwierigkeiten bereiten. Bei herkömmlichen Aktoren sind voneinander separierte Seitenbereiche des Stapels metallisch beschichtet, derart, daß die eine Beschichtung elektrisch mit den Innenelektroden der einen Gruppe und die andere Beschichtung elektrisch mit den Innenelektroden der anderen Gruppe verbunden ist.

Beim Betrieb der Aktoren werden diese metallischen Beschichtungen erheblichen mechanischen Spannungen ausgesetzt, wenn sich der Aktor entsprechend der jeweiligen Betriebsspannung ausdehnt oder zusammenzieht. Hierbei können hohe Wechselbeanspruchungen auftreten, wenn die Betriebsspannung häufig an- und abgeschaltet bzw. bezüglich ihrer Polarität umgeschaltet wird.

Diese mechanischen Beanspruchungen der metallischen Beschichtungen können zu Rissen in der Beschichtung führen, mit der Folge, daß eine mehr oder weniger große Anzahl der Innenelektroden nicht mehr an die Betriebspannungsquelle anschließbar ist und die benachbarten piezokeramischen Folien nicht mehr bzw. praktisch nicht mehr zur Arbeit des Aktors beitragen können.

In der DE 196 48 545 A1 wird deshalb vorgesehen, die vorgenannten metallischen Beschichtungen mit einer mechanisch besonders nachgiebigen, elektrisch leitenden weiteren Schicht zu bedecken, um die Fragmente der vorgenannten Beschichtung, die in der DE 196 48 545 A1 auch als Grundmetallisierung bezeichnet wird, ständig in elektrisch leitender Verbindung miteinander zu halten. Diese zusätzliche Beschichtung kann beispielsweise die Form eines Drahtgewirkes oder -geflechtes oder auch eines Metallschaums oder Wellbleches aufweisen.

Aus der DE 42 24 284 A ist ein laminatförmiges Verschiebungstransducerelement bekannt, das aus einem Stapel von Scheiben eines piezokeramischen Materials mit dazwischen liegenden alternierend angeordneten Elektroden besteht. Die alternierend angeordneten Elektroden weisen auf ihrer Außenseite leistenförmige Fortsätze auf der Basis einer Nickellegierung auf. Aus der US-A-5459371 ist ein piezoelektrisches Element bekannt, dessen Elektroden mit leistenartigen Fortsätzen versehen sind, die aus Nickel bestehen. Aus der JP 60196981 A ist ein weiteres piezoelektrisches Element bekannt, das auf seiner Außenfläche mit Kupfer beschichtet ist. Weiterhin ist aus der DE 197 53 930 A ein Verfahren zur Anbringung von Außenelektroden an Festkörperaktoren beschrieben, wobei Innenelektroden des piezokeramischen Stapels mit einer Grundmetallisierung versehen werden, die eine Nickel-Gold-Schicht umfasst. Ein weiterer piezoelektrischer Aktor mit leistenartigen Fortsätzen zur Kontaktierung der Elektroden ist aus der JP 61234580 bekannt.

### Vorteile der Erfindung

Die Erfindüng wie beansprucht beruht auf dem allgemeinen Gedanken, die Innenelektroden jeweils zumindest an einem Bereich der Außenseite des Stapels durch leistenartige bzw. fahnenartige metallische Elemente fortzusetzen, welche in bevorzugter Weise durch elektrolytisch abgeschiedenes Metall gebildet werden können. Damit können die Innenelektroden in einem gewissen Abstand von den Seitenrändern der piezokeramischen Folien miteinander elektrisch leitend verbunden werden, beispielsweise durch gegebenenfalls gewellte Metallfolien, Metallgestricke od. dgl. oder leitfähige Kunststofffolien, beispielsweise Silikonfolien, in die elektrisch leitende Partikel eingebettet sind, sodass diese Folien ein durchlaufendes flächiges elektrisches Leitungsband bilden.

Die die Innenelektroden außerhalb des piezokeramischen Stapels fortsetzenden Leisten oder Fahnen bilden also eine nicht zusammenhängend strukturierte, streifenförmige Grundmetallisierung, wobei diese Leisten oder Fahnen durch die mechanischen Bewegungen der benachbarten piezokeramischen Folien beim Betrieb des Aktors nur allenfalls wenig beansprucht werden. Indem nun diese Leisten oder Fahnen mechanisch nachgiebig miteinander elektrisch verbunden werden, kann ein besonders standfester Aktor erreicht werden.

### Zeichnung

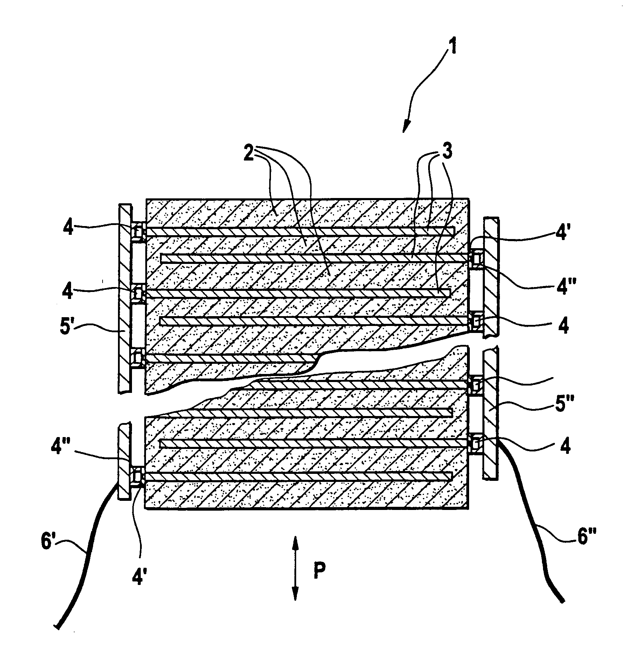

Anhand der Zeichnung wird eine besonders bevorzugte Ausführungsform der Erfindung erläutert.

Dabei zeigt die einzige Figur ein Schnittbild eines erfindungsgemäßen Aktors.

Gemäß der Zeichnung besteht ein erfindungsgemäßer piezokeramischer Aktor 1 im wesentlichen aus einem Stapel gesinterter piezokeramischer Folien 2 mit dazwischen angeordneten metallischen Innenelektroden 3, die abwechselnd bis zur rechten bzw, linken Seite des dargestellten Aktors 1 reichen, d.h. von außen zwischen den benachbarten piezokeramischen Folien 2 zugänglich sind. Am jeweils gegenüberliegenden Randbereich wird jede Innenelektrode von den benachbarten piezokeramischen Folien 2 überdeckt, so daß dort der Rand der jeweiligen Innenelektrode 3 von außen unzugänglich ist.

Durch weiter unten dargestellte elektrolytische Metallabscheidung werden an den von außen erreichbaren, in der Zeichnung rechten bzw. linken Randbereichen der Innenelektroden 3 leistenartige Fortsätze 4 angeformt, welche jeweils aus einer an die Innenelektroden 3 unmittelbar anschließenden Schicht 4' und einer außen darüberliegenden Goldschicht 4" bestehen.

Die freien Ränder der leistenartigen Fortsätze 4 sind miteinander elektrisch über elektrisch leitende Folien 5' bzw. 5" verbunden, die beispielsweise aus Kunststoff, z.B. Silikon oder Copolymeren, und darin eingelagert elektrisch leitenden Kohlenstoff- oder Metallpartikeln bestehen, wobei diese Partikel zur Erzielung der gewünschten elektrischen Leitfähigkeit sehr dicht gepackt sind und das Kunststoffmaterial im wesentlichen zur Gewährleistung des mechanischen Verbundes der Partikel dient.

Die leistenartigen Fortsätze 4 und die Folien 5' bzw. 5" können miteinander beispielsweise durch Heißverpressen elektrisch leitend verbunden sein.

Die beiden Folien 5' und 5" sind ihrerseits mit Anschlußleitungen 6' und 6" elektrisch verbunden, über die sich die Folien 5' und 5" und damit die daran elektrisch angeschlossenen Innenelektroden 3 mit einer Betriebsspannungsquelle verbinden lassen, derart, daß jeweils die mit der Folie 5' elektrisch verbundene Gruppe der Innenelektroden 3 und die kammartig zwischen die vorgenannten Innenelektroden 3 eingreifenden, mit der Folie 5" elektrisch verbundenen Innenelektroden 3 elektrisch entgegengesetzte Polaritäten aufweisen und jede dazwischenliegende piezokeramische Folie 2 mit einem entsprechenden elektrischen Feld beaufschlagt wird.

Je nach Polarität der elektrischen Betriebsspannung führen dann die oberen und unteren Enden des Aktors 1 Relativbewegungen zueinander entsprechend dem Doppelpfeil P aus.

Da die Folien 5' und 5" von den Rändern der piezokeramischen Folien 2 räumlich separiert sind, und da die Folien 5' und 5" darüber hinaus eine gewisse elastische Nachgiebigkeit besitzen, können die Bewegungen des Aktors 1 keinerlei Zerstörungen an den Folien 5' und 5" verursachen.

Gegebenenfalls können die Folien 5' und 5" auch eine gewellte Struktur aufweisen, derart, daß jeweils zwischen zwei an der Folie 5' bzw. 5" benachbart angebundenen Innenelektroden 3 bzw. deren leistenförmigen Fortsätzen 4 ein außenseitig konvexer Wulst verläuft.

Statt dessen ist es auch möglich, die leitenden Folien 5' und 5" durch Metallgestricke oder -netze oder auch durch eine Schicht aus Metallschaum zu ersetzen.

Die elektrochemische Erzeugung der leistenartigen Fortsätze 4 kann wie folgt durchgeführt werden:

Der Stapel aus den gesinterten piezokeramischen Folien 2 mit den dazwischen angeordneten Innenelektroden 3 wird in einer Halterung fixiert. Danach werden die Innenelektroden 3 miteinander auf den beiden gegenüberliegenden Seiten, in der Zeichnung auf der rechten und linken Seite des dargestellten Stapels, miteinander elektrisch kontaktiert, allerdings so, daß die jeweiligen Kontaktierungen noch einen größeren durchlaufenden Bereich der einander gegenüberliegenden Seiten des Stapels freilassen.

Sodann erfolgt eine Reinigung des Stapels in einem Neutralreiniger, beispielsweise bei einer Temperatur von 55° C und einer Behandlungszeit von fünf Minuten.

Nachfolgend erfolgt eine Spülung in vollszändig entsalztem Wasser (VE-Wasser).

Nunmehr erfolgt elektrochemische Metallabscheidung einer Nickellegierung aus einem Nickelsulfamatelektrolyt, welcher im Falle der Abscheidung einer Legierung entsprechende Zusätze bzw. Legierungskomponenten enthält.

Bei der Abscheidung werden die Innenelektroden 3 über die vorgenannten Kontaktierungen des Stapels elektrisch als Kathode geschaltet und eine geeignete Anode eingesetzt.

Der Nickelsulfamatelektrolyt kann einen pH-Wert zwischen 3 und 4 und eine Temperatur von etwa 40° C aufweisen. Weitere Elektrolyte werden bei ähnlichen Prozeßbedingungen betrieben.

Die elektrische Stromstärke zwischen Kathode und Anode kann bezogen auf die freiliegenden Keramikoberfläche bei 1 mA/cm² liegen. Damit wird eine Abscheiderate von ca. 0,1 µm/min erreicht.

Nach Erzeugung der Metallschichten 4' erfolgt einer erneute Spülung in voll entsalztem Wasser.

Anschließend erfolgt eine Hartgold-Abscheidung in einem Goldelektrolyt, wobei die Innenelektroden 3 wiederum als Kathode geschaltet werden und eine Anode aus platiniertem Titan eingesetzt werden kann. Der pH-Wert des Goldelektrolyts kann auf einen Wert von 4 bis 5 eingestellt sein. Die Temperatur kann wiederum bei 40° C liegen. Die Stromstärke kann wiederum bezogen auf die freiliegende Keramikfläche des keramischen Folienstapels bei 1 mA/cm² liegen.

Alternativ kann auch eine gleichmäßige ca. 0,1 mm dicke Goldschicht stromlos aus einem Sudgold-Elektrolyten abgeschieden werden. Die Temperatur für diesen Prozeßschritt kann bei 80° C bis 90° C liegen.

Abschließend erfolgt eine erneute Spülung in voll entsalztem Wasser.

Nunmehr stehen die leistenartigen Fortsätze 4 zur Verbindung mit den elektrisch leitenden Folien 5' und 5" od.dgl. zur Verfügung.

## Patentansprüche

1. Piezokeramischer Aktor (1), im wesentlichen bestehend aus einem monolithischen Stapel dünner piezokeramischer Folien (2), mit zwischen den Folien angeordneten Innenelektroden (3), welche auf Außenseiten des Stapels unter Bildung zumindest zweier elektrisch voneinander getrennter Elektrodengruppen miteinander elektrisch verbunden sind, wobei die Innenelektroden (3) jeweils an einem Bereich der Außenseite des Stapels leistenartige Fortsätze (4) aufweisen, **dadurch gekennzeichnet, dass** jeder leistenartige Fortsatz (4) aus einer Nickellegierungsschicht (4') sowie einer nach außen anschließenden Goldschicht (4") besteht.

2. Aktor nach Anspruch 1, **dadurch gekennzeichnet, dass** die Fortsätze (4) durch elektrolytisch abgeschiedenes Metall gebildet sind.

3. Verfahren zur Herstellung eines piezokeramischen Aktors nach einem der Ansprüche 1 bis 2, **dadurch gekennzeichnet, dass** die Fortsätze (4) elektrochemisch erzeugt werden, indem die Innenelektroden (3) als Kathode geschaltet und der monolithische Stapel in ein elektrolytisches Bad gebracht wird und eine Nickellegierung abgeschieden wird.

4. Verfahren nach Anspruch 3, **dadurch gekennzeichnet, dass** zur Bildung der Fortsätze 84) zunächst eine Nickellegierung und in einem weiteren Bad Gold abgeschieden wird.

## Claims

1. Piezoceramic actuator (1), substantially comprising a monolithic stack of thin piezoceramic films (2), with inner electrodes (3), which on outer sides of the stack are electrically connected to one another to form at least two groups of electrodes which are electrically separate from one another, arranged between the films, the inner electrodes (3) each having strip-like extensions (4) on a region of the outer side of the stack, **characterized in that** each strip-like extension (4) consists of a nickel alloy layer (4') and an outwardly adjoining gold layer (4").

2. Actuator according to Claim 1, **characterized in that** the extensions (4) are formed by electrolytically deposited metal.

3. Process for producing a piezoceramic actuator according to either of Claims 1 and 2, **characterized in that** the extensions (4) are formed electrochemically by the inner electrodes (3) being connected as cathode and the monolithic stack being introduced into an electrolytic bath, in which a nickel alloy is deposited.

4. Process according to Claim 3, **characterized in that** to form the extensions (4), first of all a nickel alloy is deposited and then gold is deposited in a further bath.

## Revendications

1. Actionneur piézocéramique (1) comprenant pour l'essentiel un empilage monolithique de feuilles piézocéramiques (2) minces avec des électrodes intérieures (3) disposées entre les feuilles et électriquement reliées les unes aux autres sur des faces extérieures l'empilage formant et au moins deux groupes d'électrodes électriquement séparés l'un de l'autre, les électrodes intérieures (3) présentant chacune des prolongements (4) en forme de baguette situés sur une zone de la face extérieure de l'empilage,
**caractérisé en ce que**
chaque prolongement (4) en forme de baguette est réalisé à partir d'une couche d'alliage de nickel (4') suivie vers l'extérieur d'une couche d'or (4").

2. Actionneur selon la revendication 1,
**caractérisé en ce que**
les prolongements (4) sont formés par un métal déposé de façon électrolytique.

3. Procédé de fabrication d'un actionneur piézocéramique selon l'une des revendications 1 à 2,
**caractérisé en ce que**
les prolongements (4) sont réalisés de façon électrochimique par montage des électrodes intérieures (3) comme cathode, introduction de l'empilage monolithique dans un bain électrolytique et dépôt d'un alliage de nickel.

4. Procédé selon la revendication 3,
**caractérisé en ce que**
pour former les prolongements (4) on dépose d'abord un alliage de nickel et ensuite de l'or dans un autre bain.
